# EUROPEAN PATENT SPECIFICATION

(11) **EP 2 903 029 B1**
(45) Date of publication and mention of the grant of the patent: **27.12.2017**
(21) Application number: 12885934.5
(22) Date of filing: 28.09.2012
(51) Int. Cl.: H01L 51/42, H01L 51/44, H01L 31/00, H01G 9/20

(54) **POLYMER SOLAR CELL AND PREPARATION METHOD THEREOF**
POLYMERE SOLARZELLE UND HERSTELLUNGSVERFAHREN DAFÜR
CELLULE SOLAIRE POLYMÈRE ET SON PROCÉDÉ DE PRÉPARATION

(43) Date of publication of application: 05.08.2015
(73) Proprietor: Ocean's King Lighting Science & Technology Co., Ltd, Shenzhen, Guangdong 518000 (CN); Shenzhen Ocean's King Lighting Engineering Co., Ltd., Shenzhen, Guangdong 518000 (CN)
(72) Inventor: ZHOU, Mingjie, Shenzhen Guangdong 518000 (CN); WANG, Ping, Shenzhen Guangdong 518000 (CN); HUANG, Hui, Shenzhen Guangdong 518000 (CN); CHEN, Jixing, Shenzhen Guangdong 518000 (CN)
(74) Representative: Johnson, Richard Alan
(86) International application number: PCT/CN2012/082257
(87) International publication number: WO 2014/047859

(56) References cited:
- WO-A1-95/04704
- CN-A- 101 640 133
- CN-A- 102 142 521
- CN-A- 102 148 332
- US-A1- 2010 174 095
- US-A1- 2011 139 253
- SEMALTIANOS N G ET AL: "Modification of the electrical properties of PEDOT:PSS by the incorporation of ZnO nanoparticles synthesized by laser ablation", CHEMICAL PHYSICS LETTERS, ELSEVIER BV, NL, vol. 484, no. 4-6, 7 January 2010 (2010-01-07), pages 283-289, XP026817319, ISSN: 0009-2614, DOI: 10.1016/J.CPLETT.2009.11.054 [retrieved on 2009-11-26]

## Description

### FIELD OF THE INVENTION

The present invention relates to the field of solar cell technique, especially to a polymer solar cell and preparation method thereof.

### BACKGROUND OF THE INVENTION

In 1982, Weinberger et al. studied photovoltaic properties of polyacetylene and produced a first significant solar cell. However, it had an extremely low photoelectric conversion efficiency of 10⁻³%. Glenis et al. then produced various polythiophene solar cells, but a common problem was low open-circuit voltage and low photoelectric conversion efficiency. Until 1986, C.W.Tang et al. greatly increased photoelectric current by introducing p-type semiconductor and n-type semiconductor into a double layer solar cell for the first time. This is a landmark in the history of development of organic polymer solar cell.

A double layer polymer solar cell comprises a positive electrode, a negative electrole and a thin film having photic activity between them. The thin film is active layer. Normally, active layer has a heterogeneous structure consisting of donor (D) and acceptor (A). Main material of donor comprises CdSe, n-polymer, C₆₀ and its derivative PCBM. A solar cell of PCBM could adopt indium tin oxide (ITO) and metal having relatively low work function as positive electrode and negative electrode, respectively. Active layer is generally obtained by mixing conjugated polymer with PCBM. In the case that the light travels through a transparent ITO and reaches conjugated polymer molecules, an exciton can form when photon energy is larger than bandgap of polymer. The exciton moves towards the interface of donor-acceptor (D/A). The difference between D/A is larger than the binding energy of the exciton, which will lead to the separation of excitons at the interface. PCBM transports electrons to the negative electrode, whereas polymer transports holes to the positive electrode ITO, thus generating photoelectric current and photovoltage.

To increase power conversion efficiency, absorption of sunlight has been normally improved by the modification of structure of material of active layer. But this method has some drawbacks, such as high cost and time-consuming. Furthermore, when the sunlight reaches the active layer, only a small amount of the light can be absorbed and utilized. Most of the sunlight passes through the cell without being utilized. Therefore, an important way to improve utilization of sunlight and increase power conversion efficiency is to improve component or structure of polymer solar cell. However, little related research has been done and reported. Semaltianos et al., Chemical Physics Letters 484 (2010) 283-289 describes modification of the electrical properties of PEDOT:PSS by the incorporation of ZnO nanoparticles synthesized by laser ablation. US 2011/0139253 A describes an organic photoelectric conversion element an organic photoelectric layer sandwiched between a first and a second electrode. WO 95/04704 describes a process for preparing zinc oxide by introducing an aqueous solution of a zinc salt into an atmosphere with a temperature sufficient to decompose the salt to the oxide.

### SUMMARY OF THE INVENTION

In order to solve the above problems, the present invention aims to provide a method for preparing polymer solar cell. Anode of the polymer solar cell of the present invention is prepared by mixing poly(3,4-ethylenedioxythiophene) (PEDOT) and polystyrene sulfonate (PSS) with zinc oxide (ZnO). Difference between anode and active layer in refractive index causes the sunlight passing through the active layer to be scattered and totally reflected, and then absorbed, thus improving utilization of the sunlight and increasing power conversion efficiency of polymer solar cell.

The present invention further provides a polymer solar cell prepared by the above method.

In a first aspect, the present invention provides a method for preparing polymer solar cell, comprising:
providing a clean glass substrate and then preparing a cathode, an electronic buffer layer and an active layer successively on the glass substrate;
preparing an anode on the active layer by the following steps:
   dissolving poly(3,4-ethylenedioxythiophene) (PEDOT) and polystyrene sulfonate (PSS) in chlorobenzene to obtain a solution of poly(3,4-ethylenedioxythiophene) and polystyrene sulfonate, where a weight of poly(3,4-ethylenedioxythiophene) and polystyrene sulfonate are in a ratio 2:1-6:1, and a percentage of poly(3,4-ethylenedioxythiophene) by weight of the solution of poly(3,4-ethylenedioxythiophene) and polystyrene sulfonate is in a range of 1%-5%;
   dissolving zinc oxide in acetic acid to obtain a zinc oxide solution with a concentration of 0.05g/ml-0.6g/ml;
   mixing the zinc oxide solution and the solution of poly(3,4-ethylenedioxythiophene) and polystyrene sulfonate in a volume ratio 1:10-3:4 to obtain a mixed solution, where a weight of zinc oxide and poly(3,4-ethylenedioxythiophene) are in a ratio 0.75:1-6:1;
   spin-coating the mixed solution on the active layer, and then drying to obtain the anode;
obtaining a polymer solar cell.

Preferably, a particle size of the zinc oxide is in a range of 50nm-200nm.

Zinc oxide is dissolved with acetic acid because acetic acid is a weak acid and is less corrosive to glass. Other concentrations of the acetic acid solutions are also permitted for the purpose of dissolving zinc oxide. After dissolving zinc oxide, water should be removed by drying. Concentration of the zinc oxide solution is ratio of the mass of zinc oxide to the volume of acetic acid. Both of density of the zinc oxide solution and density of the solution of poly(3,4-ethylenedioxythiophene) and polystyrene sulfonate are deemed to be 1mg/ml.

Molecular weight of the PEDOT is in a normal range of 13000-50000.

Preferably, the step of spin-coating is conducted at a speed of 2000 rpm-6000 rpm for 10 s-60 s.

Preferably, the step of drying is conducted in an inert atmosphere at a temperature of 50°C-200°C for 10 minutes-30 minutes.

Preferably, a thickness of the anode is in a range of 100nm-300nm.

Preferably, the glass substrate is common and commercially available glass.

Preferably, a material of the cathode is aluminium (Al), silver (Ag), gold (Au) or platinum (Pt). More preferably, material of the cathode is aluminium (Al).

Preferably, the cathode is prepared by vacuum vapor deposition, and the vapor deposition is conducted at a pressure of 2×10⁻⁵Pa-5×10⁻³Pa at a speed of 1nm/s-10nm/s.

Preferably, a thickness of the cathode is in a range of 10nm-30nm. More preferably, the thickness of the cathode is 15nm.

Preferably, a material of the electronic buffer layer is lithium fluoride (LiF), lithium carbonate (Li₂CO₃) or cesium carbonate (Cs₂CO₃). More preferably, the material of the electronic buffer layer is cesium carbonate (Cs₂CO₃).

Preferably, electronic buffer layer is prepared by vacuum vapor deposition, and the vapor deposition is conducted at a pressure of 2×10⁻⁵Pa-5×10⁻³Pa at a speed of 0.1nm/s-1nm/s.

More preferably, a thickness of the electronic buffer layer is in a range of 0.5nm-10nm. More preferably, the thickness of the electronic buffer layer is 2nm.

Preferably, material of the active layer comprises poly(3-hexylthiophene) (P3HT) and [6,6]-phenyl-C₆₁-butyric acid methyl ester (PCBM). [6,6]-phenyl-C61-butyric acid methyl ester which is derived from C₆₀ has a molecular formula of C₇₂H₁₄O₂.

Preparation of an active layer comprises: dissolving poly(3-hexylthiophene) (P3HT) and [6,6]-phenyl-C61-butyric acid methyl ester (PCBM) in a solvent to obtain a mixed solution of poly(3-hexylthiophene) (P3HT) and [6,6]-phenyl-C61-butyric acid methyl ester (PCBM), where a weight of poly(3-hexylthiophene) (P3HT) and [6,6]-phenyl-C₆₁-butyric acid methyl ester (PCBM) are in a ratio 1:0.8-1:4; spin coating the mixed solution on the electronic buffer layer in an inert atmosphere; standing for 24 hours - 48 hours at room temperature to obtain the active layer.

Preferably, a weight of poly(3-hexylthiophene) (P3HT) and [6,6]-phenyl-C₆₁-butyric acid methyl ester (PCBM) are in a ratio 1:0.8.

Preferably, preparation of the active layer further comprises a step of annealing at a temperature of 50°C-200°C for 5 minutes-100 minutes.

Preferably, a concentration of the mixed solution of poly(3-hexylthiophene) (P3HT) and [6,6]-phenyl-C₆₁-butyric acid methyl ester (PCBM) is in a range of 8 mg/ml- 24 mg/ml. More preferably, the concentration of the mixed solution of poly(3-hexylthiophene) and [6,6]-phenyl-C₆₁-butyric acid methyl ester is 18 mg/ml.

Preferably, after spin-coating the mixed solution, a step of annealing at a temperature of 200°C for 5 minutes is performed.

Preferably, the step of spin-coating is conducted at a speed of 4000 rpm-6000 rpm for 10 s-30 s.

Total reflection of the sunlight is realized by controlling ratio and concentration of P3HT and PCBM in active layer, achieving a refractive index of about 1.7.

Preferably, the solvent is methylbenzene, dimethylbenzene, chlorobenzene or chloroform.

Preferably, a thickness of the active layer is in a range of 80nm-300nm. More preferably, the thickness of the active layer is 200nm.

In a second aspect, the present invention provides a polymer solar cell comprising a glass substrate, a cathode, an electronic buffer layer, an active layer and an anode stacked successively; the anode includes poly(3,4-ethylenedioxythiophene) and polystyrene sulfonate mixed with zinc oxide; a weight of zinc oxide and poly(3,4-ethylenedioxythiophene) are in a ratio 0.75:1-6:1, and a weight of poly(3,4-ethylenedioxythiophene) and polystyrene sulfonate are in a ratio 2:1-6:1.

Preferably, a particle size of the zinc oxide is in a range of 50nm-200nm.

Preferably, a thickness of the anode is in a range of 100nm-300nm.

In the anode, zinc oxide is dissolved to ionize zinc. After the step of drying, ionic compound of zinc is formed and acts as a conductor of electricity. PEDOT is able to transport holes, which makes the anode to be able to act as a hole transport layer and anode per se.

Preferably, a thickness of the anode is in a range of 100nm-300nm.

Preferably, the glass substrate is common and commercially available glass.

Preferably, a material of the cathode is aluminium (Al), silver (Ag), gold (Au) or platinum (Pt). More preferably, the material of the cathode is aluminium (Al).

Preferably, a thickness of the cathode is in a range of 10nm-30nm. More preferably, the thickness of the cathode is 15nm.

Preferably, a material of the electronic buffer layer is lithium fluoride (LiF), lithium carbonate (Li₂CO₃) or cesium carbonate (Cs₂CO₃). More preferably, the material of the electronic buffer layer is cesium carbonate (Cs₂CO₃).

More preferably, a thickness of the electronic buffer layer is in a range of 0.5nm-10nm. More preferably, the thickness of the electronic buffer layer is 2nm.

Preferably, material of the active layer comprises poly(3-hexylthiophene) (P3HT) and [6,6]-phenyl-C₆₁-butyric acid methyl ester (PCBM). [6,6]-phenyl-C61-butyric acid methyl ester which is derived from C₆₀ has a molecular formula of C₇₂H₁₄O₂. A weight of P3HT and PCBM are in a ratio 1:0.8-1:4.

Preferably, the weight of P3HT and PCBM are in the ratio 1:0.8.

Preferably, a thickness of the active layer is in a range of 80nm-300nm. More preferably, the thickness of the active layer is 200nm.

One important factor affecting power conversion efficiency of solar cell is utilization of sunlight. Currently, a common method for increasing the absorption of sunlight is to modify the structure of the material of active layer. The present invention improves absorption of sunlight by preparing anode using mixed materials, thus increasing power conversion efficiency of polymer solar cell. The anode of the polymer solar cell of the present invention is prepared by mixing poly(3,4-ethylenedioxythiophene) (PEDOT) and polystyrene sulfonate (PSS) with zinc oxide (ZnO). PEDOT has a refractive index of about 1.5, whereas active layer of the present invention has a refractive index of about 1.7. Difference between anode and active layer in refractive index causes the sunlight passing through the active layer to be scattered and totally reflected, and then absorbed. The anode further contains zinc acetate particles, which have a large particle size and is able to scatter the light, thus improving utilization of the sunlight and increasing power conversion efficiency of polymer solar cell.

The present inventions providing polymer solar cell and preparation method thereof comprise the following benefits.

(1) In the polymer solar cell of the present invention, the light is totally reflected back to active layer and absorbed due to the difference of anode and active layer in refractive index. The anode further contains zinc acetate particles, which have a large particle size and is able to scatter the light, thus improving utilization of the light and increasing power conversion efficiency of polymer solar cell.

(2) ITO glass is usually used as an anode of polymer solar cell. However, indium element may permeate the glass, leading to a reduction of lifetime of polymer solar cell. Further, indium is a high cost rare element of a somewhat toxicity. Anode of the present invention is prepared by mixing poly(3,4-ethylenedioxythiophene) and polystyrene sulfonate with zinc oxide. The present invention has an advantage of low cost and good stability.

(3) Anode of the polymer solar cell of the present invention has a high electrical conductivity (from PEDOT and Zn ions) and high injection efficiency (from PEDOT). The anode is able to act as a hole buffer layer and anode per se. Preparation of solar cell is greatly simplified by not preparing hole buffer layer and anode separately.

(4) Some oxidizable metals, such as Al and Ag, are usually used as material of cathode. The polymer solar cell of the present invention uses a reversed structure where an electronic buffer layer, an active layer and an anode are successively prepared on a cathode. This could prevent the cathode from being oxidized and facilitate improving the lifetime of a polymer solar cell and enable the product and method to have industrialized application prospects.

### BRIEF DESCRIPTION OF THE DRAWINGS

Fig. 1 shows structure of the polymer solar cell comprising a glass substrate 1, a cathode 2, an electronic buffer layer 3, an active layer 4 and an anode 5.
Fig. 2 shows current density-voltage curves of the polymer solar cell prepared according to Example 1 and a commonly encountered polymer solar cell, corresponding to curve 1 and curve 2, respectively.

### DETAILED DESCRIPTION OF ILLUSTRATED EMBODIMENTS

The invention will now be described in detail on the basis of preferred embodiments. It is to be understood that various changes may be made.

### Example 1

A method for preparing polymer solar cell comprises the following steps.

(1) After a photolithography process, glass was cut into the size of 2× 2cm and the luminous area was 0.3× 0.3cm. The glass was then sonicated successively with detergent, deionized water, acetone, ethanol and isopropanol for 15 minutes to remove the organic pollutant on the surface of the glass.

(2) A cathode of Al and an electronic buffer layer of Cs₂CO₃ were deposited successively on the glass by using a high vacuum deposition device (Shenyang Scientific Instrument Development Center Co., Ltd. China. Pressure<1×10⁻³Pa). Cathode was deposited under a pressure of 5×10⁻⁴Pa at a speed of 5nm/s. Thickness of the cathode was 15 nm. Electronic buffer layer was deposited under a pressure of 5×10⁻⁴Pa at a speed of 0.2nm/s. Thickness of the electronic buffer layer was 2 nm.

(3) Preparation of active layer. To a stirred 0.5ml of chlorobenzene were added 5 mg of P3HT and 4 mg of PCBM to obtain a mixed solution of P3HT and PCBM with a concentration of 18 mg/ml. In a glove box filled with inert gas, the mixed solution was spin-coated on the electronic buffer layer at a speed of 5000 rpm for 15 s. This was allowed to stand for 24 hours at room temperature, and then annealed at 200°C for 5 minutes to obtain an active layer. Thickness of the active layer was 200 nm.

(4) Preparation of anode on the active layer. ZnO having a particles size of 100nm was dissolved in acetic acid to obtain a ZnO solution having a concentration of 0.4 g/ml. To chlorobenzene was added PEDOT and PSS to obtain a solution of PEDOT and PSS. Molecular weight of PEDOT is in a range of 13000-50000. In the solution of PEDOT and PSS, a weight of PEDOT and PSS are in a ratio 5:1, and the solution comprises 4% by weight of PEDOT. A weight of ZnO and PEDOT are in a ratio 5:1. According to a volume ratio of 1:2, the ZnO solution is mixed with the solution of PEDOT and PSS to obtain a second mixed solution.

The second mixed solution was spin coated on the active layer at a speed of 4000 rpm for 20 s. After that, this was dried in nitrogen gas atmosphere at 150°C for 30 minutes to obtain an anode. Thickness of the anode was 250 nm. A polymer solar cell of the present invention was made.

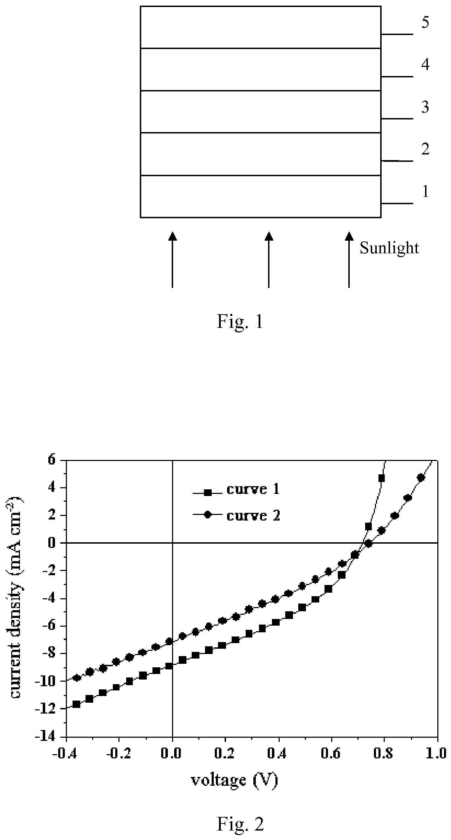

The polymer solar cell of the present invention comprises a glass substrate 1, a cathode 2, an electronic buffer layer 3, an active layer 4 and an anode 5. Fig. 1 shows the structure of the polymer solar cell of the present invention. The structure of the polymer solar cell of this embodiment can be described as: Glass substrate/Al/Cs₂CO₃/(P3HT:PCBM)/ (ZnO:PEDOT:PSS). (ZnO:PEDOT:PSS) means that the anode is prepared by mixing PEDOT and PSS with ZnO. (P3HT:PCBM) means that material of the active layer includes P3HT and PCBM.

As a comparison, a commonly encountered polymer solar cell was prepared. Structure of the comparative cell can be described as ITO/(PEDOT:PSS)/(P3HT:PCBM)/Cs₂CO₃/Al. (PEDOT:PSS) means that material of the hole buffer layer includes PEDOT and PSS. (P3HT:PCBM) means the material of the active layer includes P3HT and PCBM. Anode used herein was ITO, i.e. indium tin oxide. Thickness of ITO layer was 120nm. Material of the hole buffer layer was mixture of PEDOT and PSS. The hole buffer layer was prepared as follows. PEDOT and PSS in a ratio of 5:1 (by weight) were dissolved with water to produce an aqueous solution of PEDOT and PSS, where a mass percentage of PEDOT was 5%. The aqueous solution was then coated on the cathode by spin-coating at a speed of 5000 rpm for 15s. After drying, a hole buffer layer was obtained. The thickness of the buffer layer was 80nm. An active layer was prepared in a corresponding manner as described in Example 1. Thickness of the active layer was 200nm. An electronic buffer layer was prepared in a corresponding manner as described in Example 1. Material of the electronic buffer layer was Cs₂CO₃, and thickness of the electronic buffer layer was 2nm. A cathode was prepared in a corresponding manner as described in Example 1. Material of the cathode was Al, and thickness of the cathode was 80nm. By comparison, the present invention uses a reversed structure. Anode of the present invention is prepared by mixing hole buffer material with ZnO. The anode is able to act as a hole buffer layer and anode per se, which greatly simplifies the preparation process.

### Example 2

A method for preparing polymer solar cell comprises the following steps.

(1) After a photolithography process, glass was cut into the size of 2× 2cm and the luminous area was 0.3× 0.3cm. The glass was then sonicated successively with detergent, deionized water, acetone, ethanol and isopropanol for 15 minutes to remove the organic pollutant on the surface of the glass.

(2) A cathode of Ag and an electronic buffer layer of LiF were deposited successively on the glass by using a high vacuum deposition device (Shenyang Scientific Instrument Development Center Co., Ltd. China. Pressure<1×10⁻³Pa). Cathode was deposited under a pressure of 5×10⁻³ Pa at a speed of 10 nm/s. Thickness of the cathode was 10 nm. Electronic buffer layer was deposited under a pressure of 5×10⁻³ Pa at a speed of 1 nm/s. Thickness of the electronic buffer layer was 0.7 nm.

(3) Preparation of active layer. To a stirred 1ml of chloroform were added 4.8mg of P3HT and 19.2mg of PCBM to obtain a mixed solution of P3HT and PCBM with a concentration of 24mg/ml. In a glove box filled with inert gas, the mixed solution was spin-coated on the electronic buffer layer at a speed of 4000 rpm for 30 s. This was allowed to stand for 36 hours at room temperature to obtain an active layer. Thickness of the active layer was 80 nm.

(4) Preparation of anode on the active layer. ZnO having a particles size of 200 nm was dissolved in acetic acid to obtain a ZnO solution having a concentration of 0.6g/ml. To chlorobenzene were added PEDOT and PSS to obtain a solution of PEDOT and PSS.

Molecular weight of PEDOT is in a range of 13000-50000. In the solution of PEDOT and PSS, a weight of PEDOT and PSS are in a ratio 2:1, and the solution comprises 1% by weight of PEDOT. A weight of ZnO and PEDOT are in a ratio 6:1. According to a volume ratio of 1:10, the ZnO solution is mixed with the solution of PEDOT and PSS to obtain a second mixed solution.

The second mixed solution was spin coated on the active layer at a speed of 2000 rpm for 60 s. After that, this was dried in nitrogen gas atmosphere at 50°C for 30 minutes to obtain an anode. Thickness of the anode was 100 nm. A polymer solar cell of the present invention was made.

The polymer solar cell of the present invention comprises a glass substrate, a cathode, an electronic buffer layer, an active layer and an anode. The structure of the polymer solar cell of this embodiment can be described as: Glass substrate/Ag/LiF/(P3HT:PCBM)/ (ZnO:PEDOT:PSS). (ZnO:PEDOT:PSS) means that the anode was prepared by mixing PEDOT and PSS with ZnO. (P3HT:PCBM) means that material of the active layer includes P3HT and PCBM.

### Example 3

A method for preparing polymer solar cell comprises the following steps.

(1) After a photolithography process, glass was cut into the size of 2× 2cm and the luminous area was 0.3× 0.3cm. The glass was then sonicated successively with detergent, deionized water, acetone, ethanol and isopropanol for 15 minutes to remove the organic pollutant on the surface of the glass.

(2) A cathode of Au and an electronic buffer layer of Cs₂CO₃ were deposited successively on the glass by using a high vacuum deposition device (Shenyang Scientific Instrument Development Center Co., Ltd. China. Pressure<1×10⁻³Pa). Cathode was deposited under a pressure of 2×10⁻⁵ Pa at a speed of 1 nm/s. Thickness of the cathode was 30 nm. Electronic buffer layer was deposited under a pressure of 2×10⁻⁵ Pa at a speed of 0.1 nm/s. Thickness of the electronic buffer layer was 0.5 nm.

(3) Preparation of active layer. To a stirred 1ml of chloroform were added 4mg of P3HT and 12mg of PCBM to obtain a mixed solution of P3HT and PCBM with a concentration of 16mg/ml. In a glove box filled with inert gas, the mixed solution was spin-coated on the electronic buffer layer at a speed of 6000 rpm for 10 s. This was allowed to stand for 20 hours at room temperature, and then annealed at 100°C for 100 minutes to obtain an active layer. Thickness of the active layer was 200 nm.

(4) Preparation of anode on the active layer. ZnO having a particles size of 50 nm was dissolved in acetic acid to obtain a ZnO solution having a concentration of 0.05g/ml. To chlorobenzene were added PEDOT and PSS to obtain a solution of PEDOT and PSS.

Molecular weight of PEDOT is in a range of 13000-50000. In the solution of PEDOT and PSS, a weight of PEDOT and PSS are in a ratio 6:1, and the solution comprises 5% by weight of PEDOT. A weight of ZnO and PEDOT are in a ratio 0.75:1. According to a volume ratio of 3:4, the ZnO solution is mixed with the solution of PEDOT and PSS to obtain a second mixed solution.

The second mixed solution was spin coated on the active layer at a speed of 6000 rpm for 10 s. After that, this was dried in nitrogen gas atmosphere at 200°C for 10 minutes to obtain an anode. Thickness of the anode was 300 nm. A polymer solar cell of the present invention was made.

The polymer solar cell of the present invention comprises a glass substrate, a cathode, an electronic buffer layer, an active layer and an anode. The structure of the polymer solar cell of this embodiment can be described as: Glass substrate/Au/Cs₂CO₃/(P3HT:PCBM)/ (ZnO:PEDOT:PSS). (ZnO:PEDOT:PSS) means that the anode was prepared by mixing PEDOT and PSS with ZnO. (P3HT:PCBM) means that material of the active layer includes P3HT and PCBM.

### Example 4

A method for preparing polymer solar cell comprises the following steps.

(1) After a photolithography process, glass was cut into the size of 2× 2cm and the luminous area was 0.3× 0.3cm. The glass was then sonicated successively with detergent, deionized water, acetone, ethanol and isopropanol for 15 minutes to remove the organic pollutant on the surface of the glass.

(2) A cathode of Pt and an electronic buffer layer of Li₂CO₃ were deposited successively on the glass by using a high vacuum deposition device (Shenyang Scientific Instrument Development Center Co., Ltd. China. Pressure<1×10⁻³Pa). Cathode was deposited under a pressure of 5×10⁻⁵ Pa at a speed of 8 nm/s. Thickness of the cathode was 12 nm. Electronic buffer layer was deposited under a pressure of 5×10⁻⁵ Pa at a speed of 0.5 nm/s. Thickness of the electronic buffer layer was 10 nm.

(3) Preparation of active layer. To a stirred 1ml of chloroform were added 2.67mg of P3HT and 5.33mg of PCBM to obtain a mixed solution of P3HT and PCBM with a concentration of 8mg/ml. In a glove box filled with inert gas, the mixed solution was spin-coated on the electronic buffer layer at a speed of 5000 rpm for 20 s. This was allowed to stand for 48 hours at room temperature, and then annealed at 70°C for 100 minutes to obtain an active layer. Thickness of the active layer was 300 nm.

(4) Preparation of anode on the active layer. ZnO having a particles size of 80 nm was dissolved in acetic acid to obtain a ZnO solution having a concentration of 0.2g/ml. To chlorobenzene were added PEDOT and PSS to obtain a solution of PEDOT and PSS.

Molecular weight of PEDOT is in a range of 13000-50000. In the solution of PEDOT and PSS, a weight of PEDOT and PSS are in a ratio 3:1, and the solution comprises 2% by weight of PEDOT. A weight of ZnO and PEDOT are in a ratio 4:1. According to a volume ratio of 2:5, the ZnO solution is mixed with the solution of PEDOT and PSS to obtain a second mixed solution.

The second mixed solution was spin coated on the active layer at a speed of 2500 rpm for 30 s. After that, this was dried in nitrogen gas atmosphere at 50°C for 20 minutes to obtain an anode. Thickness of the anode was 180 nm. A polymer solar cell of the present invention was made.

The polymer solar cell of the present invention comprises a glass substrate, a cathode, an electronic buffer layer, an active layer and an anode. The structure of the polymer solar cell of this embodiment can be described as: Glass substrate/Pt/Li₂CO₃/(P3HT:PCBM)/ (ZnO:PEDOT:PSS). (ZnO:PEDOT:PSS) means that the anode was prepared by mixing PEDOT and PSS with ZnO. (P3HT:PCBM) means that material of the active layer includes P3HT and PCBM.

### Comparative Example

A current-voltage tester (Keithley instruments Inc. US. model: 2602) and a white light source were used to detect current density of the polymer solar cell while varying the voltage. The white light was simulated sunlight produced by a xenon lamp (Osram, 500W) and a light filter (AMI.5). Fig. 2 shows current density-voltage curves of the polymer solar cell prepared according to Example 1 and a commonly encountered polymer solar cell, corresponding to curve 1 and curve 2, respectively.

Current density of the polymer solar cell prepared according to Example 2-4 were detected while varying voltage. Some performance data, such as short-circuit current, open-circuit voltage, power conversion efficiency and fill factor, were obtained and shown in Table. 1. Table 1 shows performances of the polymer solar cell prepared according to Example 1-4 and the comparative cell. The symbol "η" herein is power conversion efficiency.

**Table 1 performances of the polymer solar cell prepared according to Example 1-4 and the comparative embodiment**

| Solar cell | short-circuit current (mA/cm²) | open-circuit voltage (V) | η(%) | fill factor |
|---|---|---|---|---|
| comparative embodiment | 6.18 | 0.74 | 1.40 | 0.31 |
| Example 1 | 9.46 | 0.73 | 2.37 | 0.34 |
| Example 2 | 8.00 | 0.72 | 1.89 | 0.33 |
| Example 3 | 6.51 | 0.72 | 1.52 | 0.32 |
| Example 4 | 6.65 | 0.74 | 1.67 | 0.34 |

It can be seen from Table 1 that short-circuit current and power conversion efficiency of the comparative embodiment are 6.18mA/cm² and 1.40%, respectively. However, short-circuit current of the polymer solar cell according to Examples 1-4 is increased to 6.51-9.46mA/cm², and the power conversion efficiency is in a range of 1.52%-2.37%. It indicates that the present invention uses a reversed structure. Anode of the present invention is prepared by mixing PEDOT and PSS with ZnO. Anode of the polymer solar cell of the present invention has a high electrical conductivity and high injection efficiency. The light is totally reflected back to active layer and absorbed due to the difference of anode and active layer in refractive index, thus improving utilization of the sunlight and increasing power conversion efficiency of polymer solar cell. The product and method have industrialized application prospects.

## Claims

1. A method for preparing polymer solar cell, comprising:
providing a clean glass substrate and then preparing a cathode, an electronic buffer layer and an active layer successively on the glass substrate;
preparing an anode on the active layer by the following steps:
dissolving poly(3,4-ethylenedioxythiophene) and polystyrene sulfonate in chlorobenzene to obtain a solution of poly(3,4-ethylenedioxythiophene) and polystyrene sulfonate, where a weight of poly(3,4-ethylenedioxythiophene) and polystyrene sulfonate are in a ratio 2:1-6:1, and a percentage of poly(3,4-ethylenedioxythiophene) by weight of the solution of poly(3,4-ethylenedioxythiophene) and polystyrene sulfonate is in a range of 1%-5%;
dissolving zinc oxide in acetic acid to obtain a zinc oxide solution with a concentration of 0.05g/ml-0.6g/ml;
mixing the zinc oxide solution and the solution of poly(3,4-ethylenedioxythiophene) and polystyrene sulfonate in a volume ratio 1:10-3:4 to obtain a mixed solution, where a weight of zinc oxide and poly(3,4-ethylenedioxythiophene) are in a ratio 0.75:1-6:1;
spin-coating the mixed solution on the active layer, and then drying to obtain the anode;
obtaining a polymer solar cell.

2. The method for preparing polymer solar cell of claim 1, wherein a particle size of the zinc oxide is in a range of 50nm-200nm.

3. The method for preparing polymer solar cell of claim 1, wherein the step of spin-coating is conducted at a speed of 2000 rpm-6000 rpm for 10 s-60 s.

4. The method for preparing polymer solar cell of claim 1, wherein the step of drying is conducted in an inert atmosphere at a temperature of 50°C-200°C for 10 minutes-30 minutes.

5. The method for preparing polymer solar cell of claim 1, wherein the step of preparing an active layer comprises:
dissolving poly(3-hexylthiophene) and [6,6]-phenyl-C61-butyric acid methyl ester in a solvent to obtain a mixed solution of poly(3-hexylthiophene) and [6,6]-phenyl-C61-butyric acid methyl ester, where a weight of poly(3-hexylthiophene) and [6,6]-phenyl-C₆₁-butyric acid methyl ester are in a ratio 1:0.8-1:4;
spin-coating the mixed solution of poly(3-hexylthiophene) and [6,6]-phenyl-C61-butyric acid methyl ester on the electronic buffer layer in an inert atmosphere;
standing for 24 hours - 48 hours at room temperature to obtain the active layer.

6. The method for preparing polymer solar cell of claim 5, wherein the step of preparing the active layer further comprises a step of annealing at a temperature of 50°C-200°C for 5 minutes-100 minutes.

7. The method for preparing polymer solar cell of claim 5, wherein a concentration of the mixed solution of poly(3-hexylthiophene) and [6,6]-phenyl-C₆₁-butyric acid methyl ester is in a range of 8 mg/ml- 24 mg/ml.

8. The method for preparing polymer solar cell of claim 5, wherein the step of spin-coating is conducted at a speed of 4000 rpm-6000 rpm for 10 s-30 s.

9. A polymer solar cell comprising a glass substrate, a cathode, an electronic buffer layer, an active layer and an anode stacked successively; the anode includes poly(3,4-ethylenedioxythiophene) and polystyrene sulfonate mixed with zinc oxide and zinc acetate; a weight of zinc oxide and poly(3,4-ethylenedioxythiophene) are in a ratio 0.75:1-6:1, and a weight of poly(3,4-ethylenedioxythiophene) and polystyrene sulfonate are in a ratio 2:1-6:1.

10. The polymer solar cell of claim 9, wherein a particle size of zinc oxide is in a range of 50nm-200nm; a thickness of the anode is in a range of 100 nm-300 nm.

## Patentansprüche

1. Verfahren zur Herstellung einer Polymersolarzelle, die Folgendes umfasst:
Bereitstellen eines sauberen Glassubstrats und anschließendes aufeinanderfolgendes Herstellen einer Kathode, einer Elektronenpufferschicht und einer aktiven Schicht auf dem Glassubstrat;
Herstellen einer Anode auf der aktiven Schicht mittels der folgenden Schritte:
Lösen von Poly(3,4-ethylendioxythiophen) und Polystyrolsulfonat in Chlorbenzol, um eine Lösung von Poly(3,4-ethylendioxythiophen) und Polystyrolsulfonat zu erhalten, wobei das Poly(3,4-ethylendioxythiophen) und das Polystyrolsulfonat in einem Gewichtsverhältnis von 2:1 bis 6:1 vorliegen und der Prozentsatz von Poly-(3,4-ethylendioxythiophen) in der Lösung von Poly(3,4-ethylendioxythiophen) und Polystyrolsulfonat im Bereich von 1 Gew.-% bis 5 Gew.-% der Lösung liegt;
Lösen von Zinkoxid in Essigsäure, um eine Zinkoxidlösung mit einer Konzentration von 0,05 g/ml bis 0,6 g/ml zu erhalten;
Vermischen der Zinkoxidlösung und der Lösung von Poly(3,4-ethylendioxy-thiophen) und Polystyrolsulfonat in einem Volumsverhältnis von 1:10 bis 3:4, um eine gemischte Lösung zu erhalten, wobei das Zinkoxid und das Poly(3,4-ethylendioxy-thiophen) in einem Gewichtsverhältnis von 0,75:1 bis 6:1 vorliegen;
Rotationsbeschichten der gemischten Lösung auf die aktive Schicht und anschließendes Trocknen, um die Anode zu erhalten;
Erhalten einer Polymersolarzelle.

2. Verfahren zur Herstellung einer Polymersolarzelle nach Anspruch 1, wobei die Teilchengröße des Zinkoxids im Bereich von 50 nm bis 200 nm liegt.

3. Verfahren zur Herstellung einer Polymersolarzelle nach Anspruch 1, wobei der Schritt der Rotationsbeschichtung 10 s bis 60 s lang mit einer Geschwindigkeit von 2000 U/min bis 6000 U/min durchgeführt wird.

4. Verfahren zur Herstellung einer Polymersolarzelle nach Anspruch 1, wobei der Schritt des Trocknens 10 min bis 30 min lang bei einer Temperatur von 50 °C bis 200 °C unter Inertatmosphäre durchgeführt wird.

5. Verfahren zur Herstellung einer Polymersolarzelle nach Anspruch 1, wobei der Schritt des Herstellens der aktiven Schicht Folgendes umfasst:
Lösen von Poly(3-hexylthiophen) und [6,6]-Phenyl-C₆₁-buttersäuremethylester in einem Lösungsmittel, um eine gemischte Lösung von Poly(3-hexylthiophen) und [6,6]-Phenyl-C₆₁-buttersäuremethylester zu erhalten, wobei das Poly(3-hexylthiophen) und der [6,6]-Phenyl-C₆₁-buttersäuremethylester in einem Gewichtsverhältnis von 1:0,8 bis 1:4 vorliegen;
Rotationsbeschichten der gemischten Lösung von Poly(3-hexylthiophen) und [6,6]-Phenyl-C₆₁-buttersäuremethylester unter Inertatmosphäre auf die Elektronenpufferschicht;
Stehenlassen für 24 h bis 48 h bei Raumtemperatur, um die aktive Schicht zu erhalten.

6. Verfahren zur Herstellung einer Polymersolarzelle nach Anspruch 5, wobei der Schritt des Herstellens der aktiven Schicht weiters einen Schritt der Anellierung bei einer Temperatur von 50 °C bis 200 °C, 5 min bis 100 min lang, umfasst.

7. Verfahren zur Herstellung einer Polymersolarzelle nach Anspruch 5, wobei eine Konzentration der gemischten Lösung von Poly(3-hexylthiophen) und [6,6]-Phenyl-C₆₁-buttersäuremethylester in einem Bereich von 8 mg/ml bis 24 mg/ml liegt.

8. Verfahren zur Herstellung einer Polymersolarzelle nach Anspruch 5, wobei der Schritt der Rotationsbeschichtung 10 s bis 30 s lang mit einer Geschwindigkeit von 4000 U/min bis 6000 U/min durchgeführt wird.

9. Polymersolarzelle, die ein Glassubstrat, eine Kathode, eine Elektronenpufferschicht, eine aktive Schicht und eine Anode, die nacheinander gestapelt sind, umfasst; wobei die Anode Poly(3,4-ethylendioxythiophen) und Polystyrolsulfonat im Gemisch mit Zinkoxid und Zinkacetat umfasst; das Zinkoxid und das Poly(3,4-ethylen-dioxythiophen) in einem Gewichtsverhältnis von 0,75:1 bis 6:1 vorliegen und das Poly(3,4-Ethylendioxythiophen) und das Polystyrolsulfonat in einem Gewichtsverhältnis von 2:1 bis 6:1 vorliegen.

10. Polymersolarzelle nach Anspruch 9, wobei die Partikelgröße des Zinkoxids im Bereich von 50 nm bis 200 nm liegt; und die Dicke der Anode im Bereich von 100 nm bis 300 nm liegt.

## Revendications

1. Procédé de préparation d'une cellule solaire polymère, comprenant :
la fourniture d'un substrat de verre propre et ensuite la préparation d'une cathode, d'une couche tampon électronique et d'une couche active successivement sur le substrat de verre ;
la préparation d'une anode sur la couche active par les étapes suivantes :
la dissolution de poly(3,4-éthylènedioxythiophène) et de poly(sulfonate de styrène) dans du chlorobenzène pour obtenir une solution de poly(3,4-éthylènedioxythiophène) et de poly(sulfonate de styrène), où un poids du poly(3,4-éthylènedioxythiophène) et du poly(sulfonate de styrène) sont en un rapport de 2/1 à 6/1, et un pourcentage du poly(3,4-éthylènedioxythiophène) en poids de la solution de poly(3,4-éthylènedioxythiophène) et de poly(sulfonate de styrène) se situe dans une plage de 1 % à 5 % ;
la dissolution d'oxyde de zinc dans de l'acide acétique pour obtenir une solution d'oxyde de zinc ayant une concentration de 0,05 g/ml à 0,6 g/ml ;
le mélange de la solution d'oxyde de zinc et de la solution de poly(3,4-éthylènedioxythiophène) et de poly(sulfonate de styrène) en un rapport volumique de 1/10 à 3/4 pour obtenir une solution mélangée, où un poids de l'oxyde de zinc et du poly(3,4-éthylènedioxythiophène) sont en un rapport de 0,75/1 à 6/1 ;
le dépôt à la tournette de la solution mélangée sur la couche active, et ensuite le séchage pour obtenir l'anode ;
l'obtention d'une cellule solaire polymère.

2. Procédé de préparation d'une cellule solaire polymère selon la revendication 1, dans lequel une taille de particule de l'oxyde de zinc se situe dans une plage de 50 nm à 200 nm.

3. Procédé de préparation d'une cellule solaire polymère selon la revendication 1, dans lequel l'étape de dépôt à la tournette est réalisée à une vitesse de 2 000 tr/min à 6 000 tr/min pendant 10 s à 60 s.

4. Procédé de préparation d'une cellule solaire polymère selon la revendication 1, dans lequel l'étape de séchage est réalisée dans une atmosphère inerte à une température de 50 °C à 200 °C pendant 10 minutes à 30 minutes.

5. Procédé de préparation d'une cellule solaire polymère selon la revendication 1, dans lequel l'étape de préparation d'une couche active comprend :
la dissolution de poly(3-hexylthiophène) et d'ester méthylique de l'acide [6,6]-phényl-C61-butyrique dans un solvant pour obtenir une solution mélangée de poly(3-hexylthiophène) et d'ester méthylique de l'acide [6,6]-phényl-C61-butyrique, où un poids du poly(3-hexylthiophène) et de l'ester méthylique de l'acide [6,6]-phényl-C61-butyrique sont en un rapport de 1/0,8 à 1/4 ;
le dépôt à la tournette de la solution mélangée de poly(3-hexylthiophène) et d'ester méthylique de l'acide [6,6]-phényl-C61-butyrique sur la couche tampon électronique dans une atmosphère inerte ;
le repos pendant 24 heures à 48 heures à température ambiante pour obtenir la couche active.

6. Procédé de préparation d'une cellule solaire polymère selon la revendication 5, dans lequel l'étape de préparation de la couche active comprend en outre une étape de recuit à une température de 50 °C à 200 °C pendant 5 minutes à 100 minutes.

7. Procédé de préparation d'une cellule solaire polymère selon la revendication 5, dans lequel une concentration de la solution mélangée de poly(3-hexylthiophène) et d'ester méthylique de l'acide [6,6]-phényl-C61-butyrique se situe dans une plage de 8 mg/ml à 24 mg/ml.

8. Procédé de préparation d'une cellule solaire polymère selon la revendication 5, dans lequel l'étape de dépôt à la tournette est réalisée à une vitesse de 4 000 tr/min à 6 000 tr/min pendant 10 s à 30 s.

9. Cellule solaire polymère comprenant un substrat de verre, une cathode, une couche tampon électronique, une couche active et une anode empilés successivement ; l'anode inclut du poly(3,4-éthylènedioxythiophène) et du poly(sulfonate de styrène) mélangés avec de l'oxyde de zinc et de l'acétate de zinc ; un poids de l'oxyde de zinc et du poly(3,4-éthylènedioxythiophène) sont en un rapport de 0,75/1 à 6/1, et un poids du poly(3,4-éthylènedioxythiophène) et du poly(sulfonate de styrène) sont en un rapport de 2/1 à 6/1.

10. Cellule solaire polymère selon la revendication 9, dans lequel une taille de particule d'oxyde de zinc se situe dans une plage de 50 nm à 200 nm ; une épaisseur de l'anode se situe dans une plage de 100 nm à 300 nm.
